# EUROPÄISCHE PATENTSCHRIFT

(11) **EP 3 404 430 B1**
(45) Veröffentlichungstag und Bekanntmachung des Hinweises auf die Patenterteilung: **18.09.2019**
(21) Anmeldenummer: 18171462.7
(22) Anmeldetag: 09.05.2018
(51) Int. Cl.: G01R 31/317, G01D 3/08, H04B 3/46

(54) **VERFAHREN ZUR ÜBERWACHUNG EINES BETRIEBS EINER BINÄREN SCHNITTSTELLE UND ENTSPRECHENDE BINÄRE SCHNITTSTELLE**
METHOD FOR MONITORING AN OPERATION OF A BINARY INTERFACE AND RELATED BINARY INTERFACE
PROCÉDÉ DE SURVEILLANCE DU FONCTIONNEMENT D'UNE INTERFACE BINAIRE ET INTERFACE BINAIRE CORRESPONDANTE

(30) Priorität: 15.05.2017 DE 102017208170
(43) Veröffentlichungstag der Anmeldung: 21.11.2018
(73) Patentinhaber: Pepperl+Fuchs GmbH, 68307 Mannheim (DE)
(72) Erfinder: Weiskopf, Bernhard, 68309 Mannheim (DE); Sand, Michel, 69469 Weinheim (DE)
(74) Vertreter: Patent- und Rechtsanwälte Ullrich & Naumann

(56) Entgegenhaltungen:
- DE-A1-102012 205 289
- DE-A1-102014 014 309
- US-A1- 2005 038 623
- US-A1- 2011 084 723

## Beschreibung

Die vorliegende Erfindung betrifft ein Verfahren zur Überwachung eines Betriebs einer binären Schnittstelle, wobei eine Quelle eine Information über einen Ausgang und mindestens zwei Leiter an einen Eingang einer Senke sendet, wobei ein mittels einer auf den Ausgang geschalteten Spannung definierbarer Signalspannungspegel entweder einen Ein-Zustand - positive Logik - oder einen Aus-Zustand - negative Logik - und ein bei vom Ausgang getrennter Spannung anliegender Grundspannungspegel entsprechend einen Aus- oder einen Ein-Zustand bedeutet und wobei eine Fehlererkennung hinsichtlich des Arbeitens des Ausgangs oder der Schnittstelle oder eine Querschlusserkennung hinsichtlich mindestens eines Leiters vorzugsweise über eine Überwachung der am Ausgang anliegenden Spannung erfolgt.

Des Weiteren betrifft die Erfindung eine binäre Schnittstelle, insbesondere zur Durchführung des obigen Verfahrens, mit einer Quelle und einer Senke, wobei die Quelle eine Information über einen Ausgang und mindestens zwei Leiter an einen Eingang der Senke sendet, wobei ein mittels einer auf den Ausgang geschalteten Spannung definierbarer Signalspannungspegel entweder einen Ein-Zustand - positive Logik - oder einen Aus-Zustand - negative Logik - und ein bei vom Ausgang getrennter Spannung anliegender Grundspannungspegel entsprechend einen Aus- oder einen Ein-Zustand bedeutet und wobei die Schnittstelle Mittel zur Fehlererkennung hinsichtlich des Arbeitens des Ausgangs oder der Schnittstelle oder zur Querschlusserkennung hinsichtlich mindestens eines Leiters vorzugsweise über eine Überwachung der am Ausgang anliegenden Spannung aufweist.

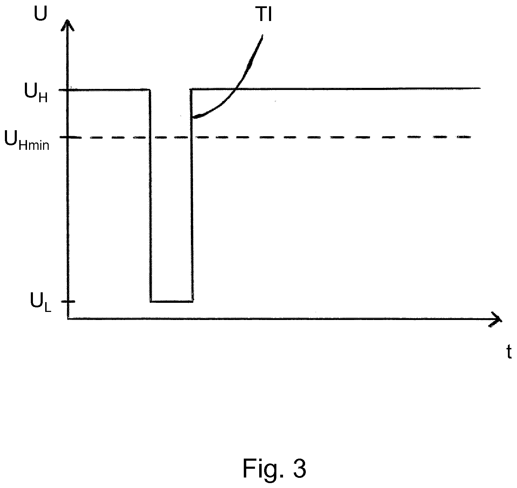

Ein Verfahren zur Überwachung eines Betriebs einer binären Schnittstelle sowie eine entsprechende binäre Schnittstelle sind aus der DE 10 2012 205 289 A1 bekannt. Aus diesem Dokument ist eine als Sensor ausgebildete binäre Schnittstelle bekannt, mit der von einer Quelle eine Information über einen Ausgang und mindestens zwei Leiter an einen Eingang einer Senke gesendet wird. Der bekannte Sensor arbeitet auf der Basis einer positiven Logik, so dass das Anlegen eines Signalspannungspegels einen Ein-Zustand bedeutet. Des Weiteren erfolgt bei dem bekannten Sensor eine Querschlusserkennung, wobei das Spannungssignal am Ausgang A2 zurückgelesen wird. Mehrere Testimpulse Al werden im Ein-Zustand gemäß Fig. 3 des Dokuments auf den Ausgang geschaltet, wobei der Test- oder Abschaltimpuls den vollen Signalhub des Signalspannungspegels zwischen H und L durchläuft und wobei nach Abschalten des Test- oder Abschaltimpulses Al der Signalspannungspegel H wieder erreicht wird.

Ein entsprechendes Verfahren zur Überwachung eines Betriebs einer binären Schnittstelle ist ebenfalls aus dem Positionspapier CB24I, "Klassifizierung binärer 24-V-Schnittstellen ...", Edition 2.0, November 2016, des Zentralverband Elektrotechnik- und Elektronikindustrie bekannt. Im Abschnitt 5.3 dieser Veröffentlichung ist ein Interface Typ C gezeigt, wobei dieses Interface eine Quelle aufweist, die eine Information über einen Ausgang und mindestens zwei Leiter an einen Eingang einer Senke sendet. Im Ein-Zustand schaltet eine Quelle eine Versorgungsspannung auf den Ausgang. Im Aus-Zustand wird der Ausgang von der Versorgungsspannung getrennt. Im Ein-Zustand sendet die Quelle Testimpulse auf den Ausgang. Die korrekte Funktion des Ausgangs wird in der Quelle selbst überwacht. Die Senke muss die Testimpulse der Quelle ausblenden, um unbeabsichtigte Schaltvorgänge zu vermeiden. Ein Versagen der Ausgangsschalteinrichtung, bspw. bei einem Haftfehler, wird in der Quelle erkannt, nicht aber in der Senke.

Weiterhin ist eine bekannte binäre Schnittstelle, bspw. für eine speicherprogrammierbare Steuerung SPS, in der Europäischen Norm EN 61131-2 beschrieben.

Des Weiteren ist aus der US 2011/084723 A1 ein Verfahren zum Testen einer Leitung bei einem programmierbaren Schaltkreis bekannt.

Bei den bekannten Verfahren und Schnittstellen, bspw. gemäß der DE 10 2012 205 289 A1, werden grundsätzlich Testimpulse verwendet, um eine Fehlererkennung oder Querschlusserkennung in Verbindung mit einem Rückleseprozess zu ermöglichen. Dabei werden relativ lange Testimpulse verwendet, die den gesamten Signalhub zwischen Signalspannungspegel H und Grundspannungspegel L durchlaufen. Insbesondere ein derart großer Signalhub erzeugt eine verhältnismäßig hohe Störaussendung mit einer Verminderung der elektromagnetischen Verträglichkeit, EMV. Des Weiteren ist problematisch, dass Testimpulse bei Eingängen mit kurzer Reaktionszeit zu Fehlsignalen führen können. Weiterhin ist bei der Verwendung von Testimpulsen problematisch, dass die jeweiligen Prüfungen durch die Testimpulse in Intervallen erfolgen, so dass Isolationsfehler oder andere Fehler zwischen zwei aufeinander folgenden Testimpulsen nicht erkannt werden. Zusätzlich reduzieren große kapazitive Lasten, bspw. durch lange Leitungen, und induktive Lasten die Verfügbarkeit der Schnittestelle, da lange Testimpulse erforderlich sind, um den vollen Signalhub zu durchlaufen. Mit anderen Worten liegt in einem solchen Fall am Eingang über eine lange Zeit kein geeigneter erforderlicher Signalspannungspegel an.

Der vorliegenden Erfindung liegt daher die Aufgabe zugrunde, ein Verfahren zur Überwachung eines Betriebs einer binären Schnittstelle sowie eine entsprechende binäre Schnittstelle anzugeben, wonach eine sichere Überwachung eines Betriebs einer binären Schnittestelle ohne wesentliche Funktionsbeeinträchtigungen auf einfache Weise ermöglicht ist.

Erfindungsgemäß wird die voranstehende Aufgabe durch ein Verfahren zur Überwachung eines Betriebs einer binären Schnittstelle mit den Merkmalen des Anspruchs 1 sowie durch eine binäre Schnittstelle mit den Merkmalen des Anspruchs 9 gelöst.

Danach ist das Verfahren derart ausgestaltet und weitergebildet, dass der Ein-Zustand und/oder der Aus-Zustand durch jeweils mindestens zwei definierbare unterschiedliche Signalspannungspegel und/oder Grundspannungspegel oder umgekehrt realisiert werden oder wird, wobei die Signalspannungspegel jeweils an unterschiedlichen Leitungsausgängen des Ausgangs anliegen, und dass mindestens ein Signalspannungspegel und/oder Grundspannungspegel zur Fehlererkennung und/oder Querschlusserkennung auf ein Abweichen seiner jeweiligen Pegelhöhe von der definierten Pegelhöhe um einen definierbaren Spannungsbetrag und/oder auf eine jeweilige Unterscheidbarkeit von dem oder den jeweils anderen Signalspannungspegeln und/oder Grundspannungspegeln überwacht wird.

Des Weiteren ist danach die erfindungsgemäße Schnittstelle derart ausgestaltet und weitergebildet, dass der Ein-Zustand und/oder der Aus-Zustand durch jeweils mindestens zwei definierbare unterschiedliche Signalspannungspegel und/oder Grundspannungspegel oder umgekehrt realisierbar sind oder ist, wobei die Signalspannungspegel jeweils an unterschiedlichen Leitungsausgängen des Ausgangs anliegen, und dass mindestens ein Signalspannungspegel und/oder Grundspannungspegel zur Fehlererkennung und/oder Querschlusserkennung auf ein Abweichen der jeweiligen Pegelhöhe von der definierten Pegelhöhe um einen definierbaren Spannungsbetrag und/oder auf eine jeweilige Unterscheidbarkeit von dem oder den jeweils anderen Signalspannungspegeln und/oder Grundspannungspegeln überwachbar ist.

In erfindungsgemäßer Weise ist zunächst erkannt worden, dass es zur sicheren Überwachung eines Betriebs einer binären Schnittstelle nicht zwingend erforderlich ist, Testimpulse zu generieren, um das Spannungsverhalten am Ausgang mit einer geeigneten Auswerteeinrichtung zu überwachen. In weiter erfindungsgemäßer Weise ist dann erkannt worden, dass eine sichere Überwachung eines Betriebs einer binären Schnittstelle auch vollständig ohne derartige Testimpulse möglich ist. In erfindungsgemäßer Weise werden hierzu zunächst der Ein-Zustand und/oder der Aus-Zustand durch jeweils mindestens zwei definierbare unterschiedliche und voneinander unterscheidbare Signalspannungspegel und/oder Grundspannungspegel oder umgekehrt realisiert. Sowohl der Ein-Zustand als auch der Aus-Zustand können durch die mindestens zwei definierbaren Signalspannungspegel oder Grundspannungspegel realisiert werden. Hier ist es lediglich die Frage, ob eine positive oder eine negative Logik realisiert werden soll. Zur Überprüfung, ob ein Querschluss oder ein Fehler im Rahmen der Schnittstellen vorliegt, können nun erfindungsgemäß zwei Überwachungsarten realisiert werden.

Bei der einen Überwachungsart wird mindestens ein Signalspannungspegel und/oder Grundspannungspegel auf ein Abweichen seiner jeweiligen Pegelhöhe - d.h. der Pegelhöhe, die während eines Betriebs oder eine Ruhezustands der Schnittstelle aktuell vorliegt - von der zuvor definierten Pegelhöhe - also Signalspannungspegelhöhe oder Grundspannungspegelhöhe - um einen definierbaren Spannungsbetrag überwacht. Mit anderen Worten wird ein Spannungsbetrag, bspw. in Abhängigkeit von einer individuellen Einsatzsituation der binären Schnittstelle, definiert, wobei ein Schwanken des mindestens einen Signalspannungspegels oder Grundspannungspegels innerhalb eines durch den Spannungsbetrag vorgegebenen Spannungsbereichs noch nicht als Fehler oder Querschluss zu werten ist. Bspw. kann der definierbare Spannungsbetrag so definiert werden, dass natürliche, bspw. temperaturbedingte Schwankungen der Signalspannungspegelhöhe oder Grundspannungspegelhöhe von dem Spannungsbetrag umfasst werden, ohne dass es bspw. zu einer Fehlermeldung kommt. Eine derartige Überwachung der Pegelhöhe kann für einen oder mehrere Signalspannungspegel und/oder Grundspannungspegel vorgesehen werden. Je mehr Signalspannungspegel und/oder Grundspannungspegel überwacht werden, umso aufwendiger ist das Verfahren, aber umso sicherer ist der Betrieb der Schnittstelle überwacht.

Die zweite erfindungsgemäße Überwachungsart besteht darin, dass bspw. in Abhängigkeit von realisierbaren Messgenauigkeiten oder sonstigen individuellen Anforderungen überwacht wird, ob der mindestens eine Signalspannungspegel und/oder Grundspannungspegel noch von dem oder den jeweils anderen Signalspannungspegeln und/oder Grundspannungspegeln unterscheidbar ist. Dabei geht es genauergesagt um eine Überwachung der Unterscheidbarkeit einerseits der Signalspannungspegel untereinander und andererseits der Grundspannungspegel untereinander. Falls hier bspw. nicht mindestens zwei Signalspannungspegel oder Grundspannungspegel voneinander unterscheidbar sind, könnte in vorteilhafter Weise eine entsprechende Reaktion und/oder Meldung erfolgen. Ob zwei Pegel noch als unterscheidbar gelten oder nicht, kann von individuellen definierbaren Schwellen, bspw. Beträgen von Spannungsdifferenzen, abhängig gemacht werden.

Mit dem erfindungsgemäßen Verfahren und der erfindungsgemäßen Schnittstelle ergeben sich vielfältige Vorteile. Zum einen wird gegenüber dem Stand der Technik die EMV durch Reduzierung einer Störaussendung signifikant erhöht, da keine Testimpulse mehr eingesetzt werden. Des Weiteren wird die Verträglichkeit mit den Eingängen verbessert, da keine Fehlsignale aufgrund von Testimpulsen mehr erzeugt werden können. Weiterhin kann sehr schnell auf Leitungsfehler oder sonstige Fehler reagiert werden, da es keine zwangsweise erzeugten Intervalle zwischen Testimpulsen gibt, innerhalb derer keine Fehlererkennung oder Querschlusserkennung möglich ist. Im Ergebnis ergibt sich weiterhin eine hohe Kompatibilität mit langen Leitungen und kapazitiven und induktiven Lasten.

Die Überwachung der am Ausgang anliegenden Spannung und die Überwachung des möglichen Abweichens der Pegel und die Überwachung auf Unterscheidbarkeit werden vorzugsweise von einer der Quelle zugeordneten Auswerteeinrichtung, bspw. eine Recheneinheit, durchgeführt.

Folglich ist mit dem erfindungsgemäßen Verfahren und der erfindungsgemäßen Schnittstelle eine sichere Überwachung eines Betriebs einer binären Schnittstelle ohne wesentliche Funktionsbeeinträchtigungen auf einfache Weise ermöglicht.

Bei binären Schnittstellen ist es üblich, dass sowohl der Ein-Zustand als auch der Aus-Zustand vorliegt und als solcher von anderen elektronischen Bauteilen erkannt wird und Berücksichtigung findet, solange sich der jeweilige Signalspannungspegel oder Grundspannungspegel in einem entsprechenden, definierbaren Spannungspegelbereich befindet. Geringfügige Schwankungen des Signalspannungspegels oder Grundspannungspegels führen folglich nicht sofort zu ungewünschten Fehlsignalen oder Fehlschaltungen, solange sich Signalspannungspegel oder Grundspannungspegel noch in dem vorgegebenen zugehörigen Spannungspegelbereich befinden. Zur Vermeidung ungewünschter Fehlsignale am Eingang können die Signalspannungspegel und/oder Grundspannungspegel in einem Spannungspegelbereich für den Ein-Zustand oder den Aus-Zustand liegen. Hierdurch wird vermieden, dass der Eingang oder die Senke von dem Ein-Zustand oder Aus-Zustand abweichende mögliche Schaltsignale oder Fehlsignale wahrnimmt. Mit anderen Worten merkt der Eingang in diesem Fall nichts davon, dass der Signalspannungspegel oder Grundspannungspegel durch mindestens zwei unterschiedliche Signalspannungspegel oder Grundspannungspegel realisiert ist.

In besonders vorteilhafter und sicherer Weise kann das Überwachen auf ein Abweichen seiner jeweiligen Pegelhöhe von der definierten Pegelhöhe um einen definierbaren Spannungsbetrag permanent während des Betriebs der Schnittstelle erfolgen. Hierdurch ist ein besonders hohes Überwachungsniveau erreicht. Je nach individuellem Anwendungsfall kann es jedoch auch ausreichen, das Überwachen zu mindestens einem vorgebbaren Zeitpunkt, d.h. auch zu mehreren vorgebbaren Zeitpunkten, durchzuführen. Alternativ hierzu und zur Erhöhung des Überwachungsniveaus kann das Überwachen auch während mindestens eines vorgebbaren Zeitintervalls, d.h. auch während mehrerer vorgebbarer Zeitintervalle, erfolgen. Hierbei ist auf den jeweiligen Anwendungsfall abzustellen.

In gleicher Weise und mit den gleichen Vorteilen kann das Überwachen auf eine jeweilige Unterscheidbarkeit von dem oder den jeweils anderen Signalspannungspegeln und/oder Grundspannungspegeln zu zumindest einem vorgebbaren Zeitpunkt, während mindestens eines vorgebbaren Zeitintervalls oder permanent erfolgen. Hinsichtlich der Vorteile der unterschiedlich gewählten Überwachungszeitpunkte oder Überwachungszeitintervalle darf zur Vermeidung von Wiederholungen auf die Ausführungen im voranstehenden Absatz verwiesen werden, die analog auch hier gelten.

Im Hinblick auf die Gewährleistung eines Betriebs der Schnittstelle lediglich in einem fehlerfreien Zustand, insbesondere ohne Querschluss, kann bei einem Abweichen seiner jeweiligen Pegelhöhe von der definierten Pegelhöhe um einen definierbaren Spannungsbetrag der Aus-Zustand hergestellt und/oder ein Fehlersignal erzeugt werden. Die quasi automatische Herstellung des Aus-Zustands gewährleistet automatisch einen Betrieb der Schnittstelle nur in fehlerfreiem Zustand. Ein derartiges Fehlersignal kann ein optisches, akustisches oder elektrisches Signal umfassen. In vorteilhafter Weise kann das Erzeugen des Fehlersignals eine optische und/oder akustische Anzeige umfassen, so dass ein Benutzer sofort auf einen fehlerhaften Betrieb hingewiesen wird. Eine entsprechende Anzeigeeinrichtung zur Darstellung eines optischen oder akustischen Signals kann in vorteilhafter Weise verwendet werden.

In gleicher Weise kann bei einer nicht mehr möglichen jeweiligen Unterscheidbarkeit des mindestens einen Signalspannungspegels und/oder Grundspannungspegels von dem oder den jeweils anderen Signalspannungspegeln und/oder Grundspannungspegeln der Aus-Zustand hergestellt und/oder ein Fehlersignal erzeugt werden. Hinsichtlich der Vorteile und vorteilhaften Möglichkeiten der Herstellung des Aus-Zustands und/oder der Erzeugung eines Fehlersignals auch bei dieser Überwachungsart bei nicht mehr möglicher Unterscheidbarkeit, darf zur Vermeidung von Wiederholungen auf die entsprechenden Ausführungen im voranstehenden Absatz verwiesen werden, die analog auch hier gelten.

Zur Realisierung der mindestens zwei unterschiedlichen Signalspannungspegel und/oder Grundspannungspegel kann der Ausgang mindestens zwei Leitungsausgänge und/oder die Quelle oder Schnittstelle entsprechende Spannungserzeugungsmittel, vorzugsweise einen Spannungsgenerator, aufweisen. Die Anzahl der Leitungsausgänge kann in vorteilhafter Weise der Anzahl unterschiedlicher Signalspannungspegel oder Grundspannungspegel entsprechen.

In vorteilhafter Weise kann eine Querschlusserkennung zwischen zwei einzelnen Leitern erkannt werden. Alternativ oder zusätzlich hierzu kann eine Querschlusserkennung zwischen einem Leiter und einer Masseleitung und/oder Versorgungsleitung erfolgen. Das erfindungsgemäße Verfahren und die erfindungsgemäße Schnittstelle sind für beide Situationen geeignet.

Bei dem erfindungsgemäßen Verfahren und der erfindungsgemäßen Schnittstelle können zur Übertragung der Zustände - Aus- und Ein-Zustand - grundsätzlich unterschiedliche Pegel innerhalb des jeweiligen Spannungspegelbereichs verwendet werden. Die Signalspannungspegel und Grundspannungspegel müssen eindeutig unterscheidbar sein. Eine nicht ausreichende Unterscheidbarkeit wird als Fehler gewertet.

Bei dem erfindungsgemäßen Verfahren und der erfindungsgemäßen Schnittstelle ist besonders vorteilhaft, dass die Signalspannungspegel und Grundspannungspegel dauernd innerhalb der Grenzen eines Spannungspegelbereichs für den Ein-Zustand oder den Aus-Zustand verbleiben können. Im Gegensatz zu den bekannten Verfahren und Schnittstellen mit Testimpulsen werden hierbei keine Störaussendungen erzeugt. Des Weiteren ist eine permanente Überwachung der Signalspannungspegel und Grundspannungspegel möglich, so dass bspw. Isolationsfehler schnell erkannt werden können. Eine Überwachung ist auch während eines Aus-Zustands möglich, ohne dass der Pegel für den Aus-Zustand verlassen werden muss. Die erfindungsgemäße Art der Überwachung des Betriebs der Schnittstelle ist tolerant im Hinblick auf große kapazitive Lasten, große induktive Lasten oder lange Leitungen, da keine "Dynamik" wie bspw. bei der immer wiederkehrenden Erzeugung von Testimpulsen auftritt.

Es gibt nun verschiedene Möglichkeiten, die Lehre der vorliegenden Erfindung in vorteilhafter Weise auszugestalten und weiterzubilden. Dazu ist einerseits auf die nachgeordneten Ansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen
- Fig. 1: in einem Diagramm einen schematischen Aufbau einer herkömmlichen Schnittstelle, die hinsichtlich ihrer Grundstruktur zur Durchführung der Ausführungsbeispiele des erfindungsgemäßen Verfahrens geeignet ist,
- Fig. 2: ein Diagramm mit einem Verlauf eines Signalspannungspegels gemäß einem Ausführungsbeispiel der Erfindung und
- Fig. 3: ein Diagramm mit einem Verlauf eines Signalspannungspegels und zusätzlichem Testimpuls gemäß dem Stand der Technik.

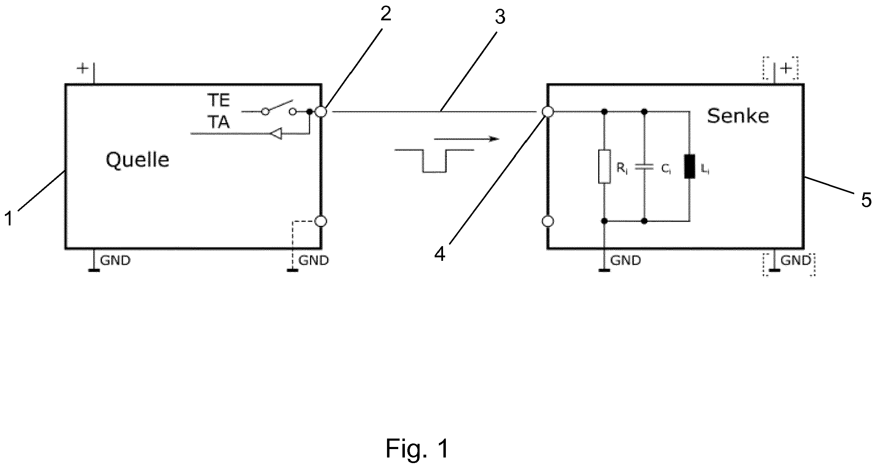

Fig. 1 zeigt in einer schematischen Darstellung eine herkömmliche Schnittstelle, die hinsichtlich ihrer Grundstruktur zur Durchführung des erfindungsgemäßen Verfahrens geeignet ist. Die Schnittstelle ist zur Überwachung eines Betriebs der Schnittstelle ausgebildet, wobei eine Quelle 1 eine Information über einen Ausgang 2 und mindestens zwei Leiter 3 an einen Eingang 4 einer Senke 5 sendet. Der Einfachheit der Darstellung halber sind die beiden Leiter 3 mit nur einem durchgezogenen Strich dargestellt. Die Quelle 1 ist mit einer Versorgungsspannung "+" versorgt und mit einer Masse GND geerdet. Die Quelle 1 weist des Weiteren eine Testimpulserzeugung TE und eine Testimpulsauswertung TA auf. Eine Information, bspw. ein Diagnosesignal oder Energie, wird in Form eines binären Signals an den Eingang 4 der Senke 5 übermittelt, wobei eine derartige binäre Information durch ein entsprechendes Symbol zwischen der Quelle 1 und der Senke 5 in Fig. 1 dargestellt ist. Die Senke 5 weist einen ohmschen Widerstand Rᵢ, eine Lastkapazität Cᵢ und eine induktive Last Lᵢ auf.

Die Überwachung des Betriebs der Schnittstelle findet in der Quelle 1 statt. Die Senke 5 muss im Hinblick auf eine sichere Funktion die Testimpulse der Quelle 1 möglichst ausblenden, um unbeabsichtigte Schaltvorgänge zu vermeiden.

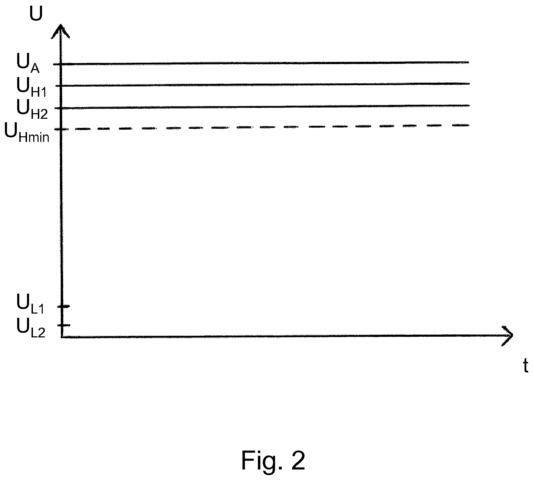

Fig. 2 zeigt in einem Diagramm einen Verlauf eines Signalspannungspegels in Abhängigkeit von der Zeit, der durch zwei unterschiedliche Signalspannungspegel U_{H1} und U_{H2} realisiert ist. Beide Signalspannungspegel U_{H1} und U_{H2} liegen bei diesem Ausführungsbeispiel in einem Spannungspegelbereich für den Ein-Zustand, wobei die minimal zulässige Signalspannung, mit der die Signalspannung noch im Spannungspegelbereich für den Ein-Zustand liegt, mit U_{Hmin} bezeichnet ist. Des Weiteren ist in dem Diagramm noch die Versorgungsspannung U_{A} für eine die Schnittstelle aufweisende Vorrichtung oder für die Schnittstelle gezeigt. Fig. 2 zeigt somit einen Ein-Zustand. Der Aus-Zustand, der bei dem hier gezeigten Ausführungsbeispiel durch einen tieferen Grundspannungspegel definiert ist, ist durch Anzeige der zugehörigen Grundspannungspegel U_{L1} und U_{L2} angedeutet. Beide Grundspannungspegel U_{L1} und U_{L2} realisieren den Grundspannungspegel.

Die Signalspannungspegel U_{H1} und U_{H2} liegen jeweils an unterschiedlichen Leitungsausgängen des Ausgangs 2 an.

Während des in Fig. 2 gezeigten Ein-Zustands werden bei dem hier gezeigten Ausführungsbeispiel beide Signalspannungspegel U_{H1} und U_{H2} zur Fehlererkennung und/oder Querschlusserkennung auf ein Abweichen ihrer jeweiligen zeitabhängigen Pegelhöhe von der zuvor definierten Pegelhöhe um einen definierbaren Spannungsbetrag überwacht. D.h., die Spannungswerte U_{H1} und U_{H2} können bei einem Auftreten eines Fehlers und/oder eines Querschlusses von den ursprünglich definierten Pegelhöhen - Signalspannungspegel U_{H1} und U_{H2} - abweichen. Falls dieses fehlerbedingte oder querschlussbedingte Abweichen den definierbaren Spannungsbetrag übersteigt, wird der Aus-Zustand hergestellt und/oder ein Fehlersignal erzeugt. Der definierbare Spannungsbetrag könnte bspw. U_{A}-U_{Hmin} sein.

Alternativ zu der Überwachung auf ein Abweichen der Pegelhöhe von der definierten Pegelhöhe um einen definierbaren Spannungsbetrag kann ein Überwachen auf eine jeweilige Unterscheidbarkeit der Signalspannungspegel U_{H1} und U_{H2} von dem jeweils anderen Signalspannungspegel U_{H2} und U_{H1} erfolgen. Falls die Unterscheidbarkeit nicht mehr gegeben sein sollte, würde auch in diesem Fall der Aus-Zustand hergestellt und/oder ein Fehlersignal erzeugt.

Beide Überwachungsarten können einzeln oder auch kumuliert durch eine geeignete Auswerteeinrichtung der Quelle durchgeführt werden.

Fig. 3 zeigt in einem Diagramm einen Verlauf eines Signalspannungspegels U_{H} in Abhängigkeit von der Zeit bei einem herkömmlichen Verfahren mit einem Testimpuls TI. Dabei ist gut erkennbar, dass der Testimpuls TI mit einem Unterschreiten des Spannungspegels unter die minimal zulässige Signalspannung U_{Hmin} einhergeht. Während des Testimpulses TI liegt somit kein Signalspannungspegel am Eingang 4 an. Ein Grundspannungspegel U_{L} wird von dem Testimpuls TI erreicht, so dass der Testimpuls TI den gesamten Signalhub durchläuft.

Hinsichtlich weiterer vorteilhafter Ausgestaltungen des erfindungsgemäßen Verfahrens und der erfindungsgemäßen Schnittstelle wird zur Vermeidung von Wiederholungen auf den allgemeinen Teil der Beschreibung sowie auf die beigefügten Ansprüche verwiesen.

Schließlich sei ausdrücklich darauf hingewiesen, dass die voranstehend beschriebenen Ausführungsbeispiele lediglich zur Erörterung der beanspruchten Lehre dienen, diese jedoch nicht auf die Ausführungsbeispiele einschränken.

### Bezugszeichenliste

- 1: Quelle
- 2: Ausgang
- 3: Leiter
- 4: Eingang
- 5: Senke
- Ci: Lastkapazität
- GND: Masse
- Lᵢ: induktive Last
- Rᵢ: Widerstand
- TA: Testimpulsauswertung
- TE: Testimpulserzeugung
- TI: Testimpuls
- U_{A}: Versorgungsspannung
- U_{H}, U_{H1}, U_{H2}: Signalspannungspegel
- U_{L}, U_{L1}, U_{L2}: Grundspannungspegel
- U_{Hmin}: minimal zulässige Signalspannung

## Patentansprüche

1. Verfahren zur Überwachung eines Betriebs einer binären Schnittstelle, wobei eine Quelle (1) eine Information über einen Ausgang (2) und mindestens zwei Leiter (3) an einen Eingang (4) einer Senke (5) sendet, wobei ein mittels einer auf den Ausgang (2) geschalteten Spannung definierbarer Signalspannungspegel (U_{H}) entweder einen Ein-Zustand - positive Logik - oder einen Aus-Zustand - negative Logik - und ein bei vom Ausgang (2) getrennter Spannung anliegender Grundspannungspegel (U_{L}) entsprechend einen Aus- oder einen Ein-Zustand bedeutet und wobei eine Fehlererkennung hinsichtlich des Arbeitens des Ausgangs (2) oder der Schnittstelle oder eine Querschlusserkennung hinsichtlich mindestens eines Leiters (3) vorzugsweise über eine Überwachung der am Ausgang (2) anliegenden Spannung erfolgt,
**dadurch gekennzeichnet,**
**dass** der Ein-Zustand und/oder der Aus-Zustand durch jeweils mindestens zwei definierbare unterschiedliche Signalspannungspegel (U_{H1}, U_{H2}) und/oder Grundspannungspegel (U_{L1}, U_{L2}) oder umgekehrt realisiert werden oder wird, wobei die Signalspannungspegel (U_{H1}, U_{H2}) jeweils an unterschiedlichen Leitungsausgängen des Ausgangs (2) anliegen, und
**dass** mindestens ein Signalspannungspegel (U_{H1}, U_{H2}) und/oder Grundspannungspegel (U_{L1}, U_{L2}) zur Fehlererkennung und/oder Querschlusserkennung auf ein Abweichen seiner jeweiligen Pegelhöhe von der definierten Pegelhöhe um einen definierbaren Spannungsbetrag und/oder auf eine jeweilige Unterscheidbarkeit von dem oder den jeweils anderen Signalspannungspegeln (U_{H1}, U_{H2}) und/oder Grundspannungspegeln (U_{L1}, U_{L2}) überwacht wird.

2. Verfahren nach Anspruch 1, **dadurch gekennzeichnet, dass** die Signalspannungspegel (U_{H1}, U_{H2}) und/oder Grundspannungspegel (U_{L1}, U_{L2}) in einem Spannungspegelbereich für den Ein-Zustand oder den Aus-Zustand liegen.

3. Verfahren nach Anspruch 1 oder 2, **dadurch gekennzeichnet, dass** das Überwachen auf ein Abweichen seiner jeweiligen Pegelhöhe von der definierten Pegelhöhe um einen definierbaren Spannungsbetrag zu mindestens einem vorgebbaren Zeitpunkt, während mindestens eines vorgebbaren Zeitintervalls oder permanent erfolgt.

4. Verfahren nach einem der Ansprüche 1 bis 3, **dadurch gekennzeichnet, dass** das Überwachen auf eine jeweilige Unterscheidbarkeit von dem oder den jeweils anderen Signalspannungspegeln (U_{H1}, U_{H2}) und/oder Grundspannungspegeln (U_{L1}, U_{L2}) zu mindestens einem vorgebbaren Zeitpunkt, während mindestens eines vorgebbaren Zeitintervalls oder permanent erfolgt.

5. Verfahren nach einem der Ansprüche 1 bis 4, **dadurch gekennzeichnet, dass** bei einem Abweichen seiner jeweiligen Pegelhöhe von der definierten Pegelhöhe um einen definierbaren Spannungsbetrag der Aus-Zustand hergestellt und/oder ein Fehlersignal erzeugt wird.

6. Verfahren nach einem der Ansprüche 1 bis 5, **dadurch gekennzeichnet, dass** bei einer nicht mehr möglichen jeweiligen Unterscheidbarkeit des mindestens einen Signalspannungspegels (U_{H1}, U_{H2}) und/oder Grundspannungspegels (U_{L1}, U_{L2}) von dem oder den jeweils anderen Signalspannungspegeln (U_{H1}, U_{H2}) und/oder Grundspannungspegeln (U_{L1}, U_{L2}) der Aus-Zustand hergestellt und/oder ein Fehlersignal erzeugt wird.

7. Verfahren nach einem der Ansprüche 1 bis 6, **dadurch gekennzeichnet, dass** der Ausgang mindestens zwei Leitungsausgänge aufweist.

8. Verfahren nach einem der Ansprüche 1 bis 7, **dadurch gekennzeichnet, dass** eine Querschlusserkennung zwischen zwei einzelnen Leitern und/oder zwischen einem Leiter und einer Masseleitung und/oder Versorgungsleitung erfolgt.

9. Binäre Schnittstelle, insbesondere zur Durchführung des Verfahrens nach einem der Ansprüche 1 bis 8, mit einer Quelle (1) und einer Senke (5), wobei die Quelle (1) eine Information über einen Ausgang (2) und mindestens zwei Leiter (3) an einen Eingang (4) der Senke (5) sendet, wobei ein mittels einer auf den Ausgang (2) geschalteten Spannung definierbarer Signalspannungspegel (U_{H}) entweder einen Ein-Zustand - positive Logik - oder einen Aus-Zustand - negative Logik - und ein bei vom Ausgang (2) getrennter Spannung anliegender Grundspannungspegel (U_{L}) entsprechend einen Aus- oder einen Ein-Zustand bedeutet und wobei die Schnittstelle Mittel zur Fehlererkennung hinsichtlich des Arbeitens des Ausgangs (2) oder der Schnittstelle oder zur Querschlusserkennung hinsichtlich mindestens eines Leiters (3) vorzugsweise über eine Überwachung der am Ausgang (2) anliegenden Spannung aufweist,
**dadurch gekennzeichnet,**
**dass** der Ein-Zustand und/oder der Aus-Zustand durch jeweils mindestens zwei definierbare unterschiedliche Signalspannungspegel (U_{H1}, U_{H2}) und/oder Grundspannungspegel (U_{L1}, U_{L2}) oder umgekehrt realisierbar sind oder ist, wobei die Signalspannungspegel (U_{H1}, U_{H2}) jeweils an unterschiedlichen Leitungsausgängen des Ausgangs (2) anliegen, und
**dass** mindestens ein Signalspannungspegel (U_{H1}, U_{H2}) und/oder Grundspannungspegel (U_{L1}, U_{L2}) zur Fehlererkennung und/oder Querschlusserkennung auf ein Abweichen der jeweiligen Pegelhöhe von der definierten Pegelhöhe um einen definierbaren Spannungsbetrag und/oder auf eine jeweilige Unterscheidbarkeit von dem oder den jeweils anderen Signalspannungspegeln (U_{H1}, U_{H2}) und/oder Grundspannungspegeln (U_{L1}, U_{L2}) überwachbar ist.

## Claims

1. Method for monitoring an operation of a binary interface, wherein a source (1) transmits an information item via an output (2) and at least two conductors (3) to an input (4) of a sink (5), wherein a signal voltage level (U_{H}) which can be defined by means of a voltage which is connected to the output (2) means either an on state - positive logic - or an off state - negative logic - and a base voltage level (U_{L}) which is applied when the voltage is separated from the output (2) accordingly means an off or on state, and wherein an error identification with regard to the operation of the output (2) or the interface or a cross-fault identification with regard to at least one conductor (3) is preferably carried out by means of monitoring the voltage applied at the output (2),
**characterised in that**
the on state and/or the off state is/are produced in each case by means of at least two definable different signal voltage levels (U_{H1}, U_{H2}) and/or base voltage levels (U_{L1}, U_{L2}) or vice versa, wherein the signal voltage levels (U_{H1}, U_{H2}) are each applied at different line outputs of the output (2), and
**in that** at least one signal voltage level (U_{H1}, U_{H2}) and/or base voltage level (U_{L1}, U_{L2}) for error identification and/or cross-fault identification are monitored for a deviation of the respective level height thereof from the defined level height by a definable voltage value and/or for any distinguishability from the other signal voltage level(s) (U_{H1}, U_{H2}) and/or base voltage levels (U_{L1}, U_{L2}).

2. Method according to claim 1, **characterised in that** the signal voltage levels (U_{H1}, U_{H2}) and/or base voltage levels (U_{L1}, U_{L2}) are located in a voltage level range for the on state or the off state.

3. Method according to claim 1 or claim 2, **characterised in that** the monitoring for a deviation of the respective level height thereof from the defined level height by a definable voltage value is carried out at least at one predeterminable time, during at least one predeterminable time range or permanently.

4. Method according to any one of claims 1 to 3,
**characterised in that** the monitoring for a respective distinguishability from the other signal voltage level(s) (U_{H1}, U_{H2}) and/or base voltage levels (U_{L1}, U_{L2}) is carried out at least at one predeterminable time, during at least one predeterminable time range or permanently.

5. Method according to any one of claims 1 to 4,
**characterised in that** in the event of a deviation of the respective level height thereof from the defined level height by a definable voltage value, the off state is produced and/or an error signal is produced.

6. Method according to any one of claims 1 to 5,
**characterised in that**, in the event that it is no longer possible to distinguish the at least one signal voltage level (U_{H1}, U_{H2}) and/or base voltage level (U_{L1}, U_{L2}) from the other signal voltage levels (U_{H1}, U_{H2}) and/or base voltage levels (U_{L1}, U_{L2}), the off state is produced and/or an error signal is produced.

7. Method according to any one of claims 1 to 6,
**characterised in that** the output has at least two line outputs.

8. Method according to any one of claims 1 to 7,
**characterised in that** a cross-fault identification is carried out between two individual conductors and/or between a conductor and an earth line and/or supply line.

9. Binary interface, in particular for carrying out the method according to any one of claims 1 to 8, having a source (1) and a sink (5), wherein the source (1) transmits an information item via an output (2) and at least two conductors (3) to an input (4) of the sink (5), wherein a signal voltage level (U_{H}) which can be defined by means of a voltage which is connected to the output (2) means either an on state - positive logic - or an off state - negative logic - and a base voltage level (U_{L}) which is applied when the voltage is separated from the output (2) accordingly means an off or on state, and wherein the interface has means for error identification with regard to the operation of the output (2) or the interface or for cross-fault identification with regard to at least one conductor (3) preferably by means of monitoring the voltage applied at the output (2),
**characterised in that**
the on state and/or the off state can be produced in each case by means of at least two definable different signal voltage levels (U_{H1}, U_{H2}) and/or base voltage levels (U_{L1}, U_{L2}) or vice versa, wherein the signal voltage levels (U_{H1}, U_{H2}) are each applied at different line outputs of the output (2), and
**in that** at least one signal voltage level (U_{H1}, U_{H2}) and/or base voltage level (U_{L1}, U_{L2}) for error identification and/or cross-fault identification can be monitored for a deviation of a respective level height from the defined level height by a definable voltage value and/or for any distinguishability from the other signal voltage level (s) (U_{H1}, U_{H2}) and/or base voltage levels (U_{L1}, U_{L2}).

## Revendications

1. Procédé de surveillance d'un fonctionnement d'une interface binaire, dans lequel une source (1) envoie à une entrée (4) d'un collecteur (5) une information par le biais d'une sortie (2) et d'au moins deux conducteurs (3), dans lequel un niveau de tension de signal (U_{H}) définissable au moyen d'une tension commutée sur la sortie (2) signifie soit un état ON - logique positive - soit un état OFF - logique négative - et un niveau de tension de base (U_{L}) présent lorsque la tension est séparée de la sortie (2) signifie en conséquence un état OFF ou un état ON, et dans lequel une détection d'erreur concernant le fonctionnement de la sortie (2) ou de l'interface, ou une détection de courts-circuits transversaux concernant au moins un conducteur (3) s'effectue de préférence par le biais d'une surveillance de la tension présente à la sortie (2),
**caractérisé en ce que**
l'état ON et/ou l'état OFF est ou sont réalisés par respectivement au moins deux niveaux de tension de signal (U_{H1}, U_{H2}) et/ou niveaux de tension de base (U_{L1},U_{L2}) différents définissables ou inversement, dans lequel les niveaux de tension de signal (U_{H1}, U_{H2}) sont présents respectivement au niveau de différentes sorties de ligne de la sortie (2), et
**en ce qu'**au moins un niveau de tension de signal (U_{H1}, U_{H2}) et/ou niveau de tension de base (U_{L1},U_{L2}) est surveillé pour la détection d'erreur et/ou pour la détection de courts-circuits transversaux à la recherche d'une divergence, égale à une valeur de tension définissable, de sa hauteur de niveau respective par rapport à la hauteur de niveau définie et/ou à la recherche d'une distinction respective par rapport à l'autre ou aux autres niveaux de tension de signal (U_{H1}, U_{H2}) et/ou niveaux de tension de base (U_{L1},U_{L2}) respectifs.

2. Procédé selon la revendication 1, **caractérisé en ce que** les niveaux de tension de signal (U_{H1}, U_{H2}) et/ou niveaux de tension de base (U_{L1},U_{L2}) se situent dans une plage de niveaux de tension pour l'état ON ou l'état OFF.

3. Procédé selon la revendication 1 ou 2, **caractérisé en ce que** la surveillance à recherche d'une divergence, égale à une valeur de tension définissable, de sa hauteur de niveau respective par rapport à la hauteur de niveau définie s'effectue au moins à un moment spécifiable au préalable, pendant au moins un intervalle de temps spécifiable au préalable ou de façon permanente.

4. Procédé selon l'une des revendications 1 à 3, **caractérisé en ce que** la surveillance à la recherche d'une distinction respective par rapport à l'autre ou aux autres niveaux de tension de signal (U_{H1}, U_{H2}) et/ou niveaux de tension de base (U_{L1},U_{L2}) respectifs s'effectue au moins à un moment spécifiable au préalable, pendant au moins un intervalle de temps spécifiable au préalable ou de façon permanente.

5. Procédé selon l'une des revendications 1 à 4, **caractérisé en ce que** l'état OFF est établi et/ou un signal d'erreur est produit lors d'une divergence, égale à une valeur de tension définissable, de sa hauteur de niveau respective par rapport à la hauteur de niveau définie.

6. Procédé selon l'une des revendications 1 à 5, **caractérisé en ce que** l'état OFF est établi et/ou un signal d'erreur est produit dans le cas d'une distinction respective qui n'est plus possible du au moins un niveau de tension de signal (U_{H1}, U_{H2}) et/ou niveau de tension de base (U_{L1},U_{L2}) par rapport à l'autre ou respectivement aux autres niveaux de tension de signal (U_{H1}, U_{H2}) et/ou niveaux de tension de base (U_{L1},U_{L2}).

7. Procédé selon l'une des revendications 1 à 6, **caractérisé en ce que** la sortie comporte au moins deux sorties de ligne.

8. Procédé selon l'une des revendications 1 à 7, **caractérisé en ce qu'**une détection de courts-circuits transversaux est effectuée entre deux conducteurs individuels et/ou entre un conducteur et une ligne de masse et/ou ligne d'alimentation.

9. Interface binaire, en particulier pour la réalisation du procédé selon l'une des revendications 1 à 8, avec une source (1) et un collecteur (5), dans lequel la source (1) envoie une information par le biais d'une sortie (2) et d'au moins deux conducteurs (3) à une entrée (4) du collecteur (5), dans lequel un niveau de tension de signal (U_{H}) définissable au moyen d'une tension commutée sur la sortie (2) signifie soit un état ON - logique positive - soit un état OFF - logique négative - et un niveau de tension de base (U_{L}) présent lorsque la tension est séparée de la sortie (2) signifie en conséquence un état OFF ou un état ON, et dans lequel l'interface comporte des moyens de détection d'erreur concernant le fonctionnement de la sortie (2) ou de l'interface, ou de détection de courts-circuits transversaux concernant au moins un conducteur (3) de préférence par le biais d'une surveillance de la tension présente à la sortie (2),
**caractérisé en ce que**
l'état ON et/ou l'état OFF peuvent ou peut être réalisé(s) par respectivement au moins deux niveaux de tension de signal (U_{H1}, U_{H2}) et/ou niveaux de tension de base (U_{L1},U_{L2}) différents définissables ou inversement, dans lequel les niveaux de tension de signal (U_{H1}, U_{H2}) sont respectivement présents au niveau de différentes sorties de ligne de la sortie (2), et
**en ce qu'**au moins un niveau de tension de signal (U_{H1}, U_{H2}) et/ou niveau de tension de base (U_{L1},U_{L2}) peut être surveillé pour la détection d'erreur et/ou pour la détection de courts-circuits transversaux à la recherche d'une divergence, égale à une valeur de tension définissable, de la hauteur de niveau respective par rapport à la hauteur de niveau définie et/ou à la recherche d'une distinction respective par rapport à l'autre ou aux autres niveaux de tension de signal (U_{H1}, U_{H2}) et/ou niveaux de tension de base (U_{L1},U_{L2}) respectifs.
